# EUROPÄISCHE PATENTSCHRIFT

(11) **EP 0 538 726 B1**
(45) Veröffentlichungstag und Bekanntmachung des Hinweises auf die Patenterteilung: **14.08.1996**
(21) Anmeldenummer: 92117543.6
(22) Anmeldetag: 14.10.1992
(51) Int. Cl.: H01L 21/321, H01J 37/32

(54) **Verfahren zur Strukturierung einer Polysiliziumschicht**
Process for forming a pattern in a polysilicon layer
Procédé pour structurer une couche de polysilicium

(30) Priorität: 23.10.1991 DE 4135033
(43) Veröffentlichungstag der Anmeldung: 28.04.1993
(73) Patentinhaber: SIEMENS AKTIENGESELLSCHAFT, 80333 München (DE)
(72) Erfinder: Engelhardt, Manfred, Dr., W-8152 Feldkirchen-Westerham (DE)

(56) Entgegenhaltungen:
- WO-A-86/03886
- US-A- 4 786 359
- PROCEEDINGS OF THE ELECTROCHEMICAL SOCIETY, NEW YORK, US Nr. 9, 1989, Seiten 486 - 497 DAVIES ET AL 'Enhancement of selectivity in a polysilicon triode etch process using independent bias voltage control in conjunction with Br2 and Cl2 plasmas'
- APPLIED PHYSICS LETTERS. Bd. 34, Nr. 3, 1. Februar 1979, NEW YORK US Seiten 192 - 193 MINKIEWICZ ET AL 'Triode plasma etching'

## Beschreibung

In der Halbleitertechnologie zur Herstellung hochintegrierter Schaltungen werden vielfach plasmaunterstützte Ätzprozesse zur Erzeugung von feinen Strukturen eingesetzt. Dazu wird auf einer zu strukturierenden Schicht eine Ätzmaske angeordnet. Die Strukturen der Ätzmaske sollen in dem anisotropen Ätzprozeß maßhaltig in die zu strukturierende Schicht übertragen werden. Eine unter der zu strukturierenden Schicht angeordnete untere Schicht soll von dem Ätzprozeß möglichst nicht angegriffen werden. Daher wird an den Ätzprozeß neben der Forderung hoher Anisotropie auch die Forderung der hohen Selektivität relativ zur unteren Schicht gestellt.

Dieses Problem ist besonders gravierend, wenn die zu strukturierende Schicht auf einer unebenen Oberfläche angeordnet ist, dies ist bei der Herstellung integrierter Schaltungen meistens unvermeidbar. Besonders ist dies der Fall bei der Strukturierung einer Polysiliziumschicht, die auf einer dünnen SiO₂-Schicht angeordnet ist. Dieses Beispiel tritt bei der Herstellung von Gateelektroden aus Polysilizium auf einer ganzflächig erzeugten Gateoxidschicht bei der Herstellung von Logik- oder Speicherschaltungen auf.

Weist die Oberfläche, auf der die zu strukturierende Schicht angeordnet ist, senkrechte Flanken auf, so bilden sich an diesen senkrechten Flanken bei dem anisotropen Ätzprozeß Flankenbedeckungen, sogenannte Spacer. Um diese zu entfernen, muß der Ätzprozeß fortgesetzt werden, auch wenn die untere Schicht schon in großen Teilen freigelegt ist. Dieses Vorgehen wird als "Überätzen" bezeichnet. Damit die untere Schicht dabei nicht angegriffen wird, ist eine hohe Selektivität der Ätzung erforderlich.

In dem Beispiel einer zu strukturierenden Schicht aus Polysilizium auf einer unteren Schicht aus SiO₂ zur Herstellung einer Gateelektrode ist es besonders wichtig, die Flankenbedeckungen vollständig zu entfernen, da diese zu Kurzschlüssen in der fertigen Schaltungsstruktur führen würden.

Aus S. Samukawa et al, J. Vac. Sci. Technol. B 8 (6) p. 1192, Nov/Dec 1990 ist bekannt, die Selektivität eines Ätzprozesses zur Strukturierung von Polysilizium relativ zu SiO₂ durch Zugabe von O₂ als zusätzlichen Prozeßgas zu Cl₂ als Prozeßgas zu vergrößern.

Eine weitere Möglichkeit besteht in der Änderung der Prozeßchemie, zum Beispiel die Chlorchemie durch eine Bromchemie zu ersetzen.

Mit diesen Maßnahmen kann jedoch grundsätzlich nur eine endliche Erhöhung der Selektivität erzielt werden, so daß die untere Schicht stets eine Mindestdicke aufweisen muß, um dem Überätzen bei der Entfernung von Flankenbedeckungen widerstehen zu können. Die Dicke der unteren Schicht bestimmt die maximale Dauer des Überätzens.

Bei Verwendung eines CF₃Br enthaltenden Prozeßgases kommt es zu einer verstärkten Polymerbildung während der Ätzreaktion. Diese Polymere schlagen sich im Plasmareaktor nieder und stellen so eine Quelle für Kontamination dar. In US-PS 4 786 359 ist vorgeschlagen worden, im Reaktor eine Hilfsstruktur vorzusehen, die während dem Ätzprozeß erodiert und so den Niederschlag von Polymeren im Ätzreaktor vermeidet. Diese Struktur ist kohlenstoffhaltig und wird vorzugsweise aus einem Kunststoff oder Graphit gebildet.

Der Erfindung liegt das Problem zugrunde, ein Verfahren zur Strukturierung einer Schicht anzugeben, bei dem in einem Ätzprozeß eine unter der zu strukturierenden Schicht angeordnete untere Schicht gegen den Ätzangriff geschützt ist.

Dieses Problem wird erfindungsgemäß gelost durch ein Verfahren nach Anspruch 1.

In dem erfindungsgemäßen Verfahren wird ausgenutzt, daß Plasmen je nach Wahl der Prozeßparameter sowohl zum Ätzen als auch zum Abscheiden von Schichten im sogenannten Sputterverfahren Einsatz finden. Das erfindungsgemäße Verfahren wird in einem Ätzreaktor durchgeführt, in dem über den Scheibenhalter eine RF-Leistung einer ersten Frequenz und unabhängig davon über eine Ringelektrode eine RF-Leistung einer zweiten Hochfrequenz angelegt wird. Über den Scheibenhalter wird die Ionenenergie und damit der Ätzprozeß gesteuert. Über die Ringelektrode wird die Ionendichte eingestellt. Durch Einstellung einer hohen Ionendichte der Teilchensorte des Materials der unteren Schicht wird erzielt, daß diese Teilchen häufig Stöße erleiden. Infolge dessen haben diese Teilchen nur eine geringe Energie und tragen zum Ätzprozeß nicht bei. Diese Teilchen lagern sich auf freigelegten Oberflächen der unteren Schicht an, da diese aus demselben Material bestehen und damit als Keim für die Schichtbildung dienen.

Die an der Ringelektrode eingekoppelte RF-Leistung wird so eingestellt, daß das Schichtwachstum auf den freiliegenden Oberflächen der unteren Schicht im wesentlichen dem Ätzangriff des Ätzprozesses an diesen Oberflächen entspricht. Auf diese Weise ändert sich die Dicke der unteren Schicht im Ergebnis nicht. Dieses hat zur Folge, daß bei der Strukturierung der Schicht aus vorgegebenem Material der Ätzprozeß beliebig lang fortgesetzt werden kann, wenn die Oberfläche der unteren Schicht freigelegt ist. Die Selektivität der Ätzung wird auf diese Weise effektiv verbessert.

Durch Verwendung eines Ätzreaktors mit Permanentmagneten zum Einschluß des Plasmas werden auch bei niedrigen Gasdrücken hohe Anisotropien erreicht. Darüberhinaus ist es in einem solchen Ätzreaktor möglich bei niedrigen Gasdrücken unter Verwendung von ausschließlich Cl₂, Br₂ oder einem Cl₂/Br₂-Gemisch ein stabiles Plasma zu zünden. Niedrige Gasdrücke in diesem Zusammenhang sind Drücke unter 1.3 Pa (10 mTorr).

Es liegt insbesondere im Rahmen der Erfindung, einen Ätzreaktor zu verwenden, in dem dem Scheibenhalter gegenüber eine geerdete Elektrode angeordnet ist und in dem die Ringelektrode und die geerdete Elektrode mit Permanentmagneten versehen sind. Dabei wird im Ätzreaktor ein Gasdruck unter 1.3 Pa (10 mTorr) eingestellt. An die Ringelektrode wird eine RF-Leistung mit einer Frequenz von 13,56 MHz und über den Scheibenhalter eine RF-Leistung mit einer Frequenz von 100 kHz angelegt.

Das Verfahren ist vorteilhaft einsetzbar zur Herstellung einer Gateelektrode aus Polysilizium. In diesem Fall besteht die zu strukturierende Schicht aus Polysilizium und die untere Schicht aus SiO₂. Die untere Schicht ist dann die Gateoxidschicht die typischerweise eine Dicke von 10 - 20 nm aufweist. Weil die Gateoxidschicht unmittelbar auf einem einkristallinen Siliziumsubstrat angeordnet ist, ist es besonders wichtig, daß diese während des anisotropen Ätzprozesses nicht zerstört wird. Die Gateoxidschicht soll die Oberfläche des einkristallinen Siliziumsubstrats vor dem Angriff des Ätzprozesses schützen.

Es liegt im Rahmen der Erfindung, bei der Strukturierung der Schicht aus Polysilizium auf einer unteren Schicht aus SiO₂ als Target eine Auskleidung des Ätzreaktors aus Quarz zu verwenden. Die Auskleidung deckt dabei mindestens die Ringelektrode und die geerdete Elektrode ab. Die Auskleidung weist Öffnungen für einen Gaseinlaß auf. Die Auskleidung aus Quarz hat neben ihrer Rolle als Target die Wirkung, daß das im Ätzprozeß angeregte Plasma nicht in direkten Kontakt mit der Ringelektrode oder der geerdeten Elektrode kommt. Dadurch wird eine Erosion der Elektroden im Betrieb vermieden. Da die Elektroden in der Praxis mit Al₂O₃ beschichtet sind, führt eine solche Erosion zu Metallkontaminationen des Substrats. Die Verwendung einer Quarzabdeckung auf der Elektroden hat den Vorteil, eine solche Kontamination zu vermeiden.

Ein Vorteil der Abdeckung aus Quarz auf der Ringelektrode besteht darin, daß die Abscheidung von SiO₂ auf den freiliegenden Oberflächen der unteren Schicht besonders gleichmäßig erfolgt, da die Quarzabdeckung das Substrat ringförmig umgibt.

Weitere Ausgestaltungen der Erfindung gehen aus den übrigen Ansprüchen hervor.

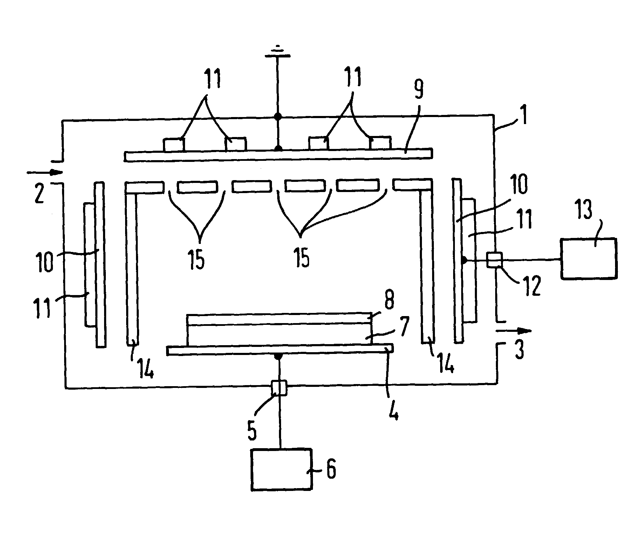

Im folgenden wird die Erfindung anhand eines Ausführungsbeispiels und der Figur näher erläutert.

In der Figur ist ein Ätzreaktor dargestellt, der für das erfindungsgemäße Verfahren geeignet ist.

Der Ätzreaktor umfaßt eine Ätzkammer 1, die geerdet ist. Die Ätzkammer 1 ist mit einem Gaseinlaß 2 und einem Gasauslaß 3 versehen.

In der Ätzkammer 1 ist ein Scheibenhalter 4 angeordnet. Der Scheibenhalter 4 ist über eine Durchführung 5 mit einem 100 kHz-Generator 6 verbunden. Auf dem Scheibenhalter 4 ist ein Substrat 7 angeordnet. Auf dem Substrat 7 ist ein Schichtaufbau 8 angeordnet. Der Schichtaufbau 8 umfaßt eine untere Schicht, die unmittelbar auf dem Substrat 7 angeordnet ist und die z. B. aus SiO₂ besteht. Auf der unteren Schicht ist eine zu strukturierende Schicht aus z. B. Polysilizium angeordnet. Auf der zu strukturierenden Schicht ist eine Ätzmaske angeordnet.

Gegenüber dem Scheibenhalter 4 ist in der Ätzkammer 1 eine Elektrode 9 angeordnet, die geerdet ist. Des weiteren ist in der Ätzkammer 1 eine Ringelektrode 10 angeordnet. Die Ringelektrode 10 umgibt den zwischen der Elektrode 9 und dem Scheibenhalter 4 aufgespannten Raum ringförmig. Die Ringelektrode 10 und die Elektrode 9 sind mit Permanentmagneten 11 versehen. Die Ringelektrode 10 ist über eine Durchführung 12 mit einem 13,56 MHz-Generator 13 verbunden.

In der Ätzkammer 1 ist schließlich eine Quarzabdeckung 14 angeordnet. Die Quarzabdeckung befindet sich zwischen der Ringelektrode 10 und dem Substrat 7 sowie zwischen der Elektrode 9 und dem Substrat 7. Die Quarzabdeckung 14 verhindert den direkten Kontakt zwischen einem im Betrieb erzeugten Plasma und der Ringelektrode 10 sowie der Elektrode 9. In der Quarzabdeckung 14 sind Öffnungen 15 vorgesehen, um den Gasdurchfluß durch die Ätzkammer 1 sicherzustellen.

Die Quarzabdeckung 14 wirkt in der Ätzkammer 1 als Target. Im Betrieb der Ätzkammer 1, d. h. bei eingeschaltetem 13,56 MHz-Generator 13 und eingeschaltetem 100 kHz-Generator 6 kommt es zu einem Sputterabtrag der Quarzabdeckung 14.

Die RF-Leistungen am 13,56 MHz-Generator 13 und dem 100 kHz-Generator 6 sind unabhängig voneinander einstellbar. Durch eine Erhöhung der 13,56 MHz RF-Leistung wird eine Erhöhung des Sputterabtrags an der Quarzabdeckung 14 erzielt. Dadurch kommt es zu einer erhöhten Ablagerung von SiO₂ auf freiliegenden Oberflächen der unteren Schicht im Schichtaufbau 8 auf dem Substrat 7. Eine Verringerung der 100 kHz RF-Leistung dagegen führt zu einer Verringerung des Ätzangriffs an dem auf dem Substrat 7 angeordneten Schichtaufbau. Auf diese Weise wird die 13,56 MHz RF-Leistung und die 100 kHz RF-Leistung so eingestellt, daß sich die Abscheidung von SiO₂ und der Ätzangriff am SiO₂ auf dem Substrat die Waage halten.

Die zu strukturierende Schicht aus Polysilizium auf einer unteren Schicht aus SiO₂ kann z. B. unter Verwendung der folgenden Prozeßparameter geätzt werden:
Die 13,56 MHz RF-Leistung wird auf 1000 Watt eingestellt. Als Ätzgas wird reines Cl₂ verwendet, das mit einem Durchfluß von 20 sccm durch die Kammer geleitet wird. Der Druck in der Ätzkammer beträgt 0.26 Pa (2mTorr). In einem ersten Schritt wird die 100 kHz RF-Leistung auf 50 Watt eingestellt. Mit dieser Leistung wird der Ätzprozeß 10 Sekunden betrieben. In diesem ersten Schritt wird das sogenannte Lageroxid, eine dünne SiO₂-Schicht, die sich stets an der Oberfläche vom Silizium befindet, entfernt. In einem zweiten Schritt wird die 100 kHz RF-Leistung mit 30 Watt eingestellt. Mit dieser Leistung wird die Ätzung z. B. 60 Sekunden durchgeführt, um eine z. B. 200 nm dicke Schicht aus Polysilizium zu ätzen. Dabei werden waagerechte Teile der zu strukturierenden Schicht aus Polysilizium vollständig entfernt. Unter diesen vormals waagerechten Teilen der Polysiliziumschicht wird die Oberfläche der unteren Schicht freigelegt. In einem dritten Schritt werden an Stufen verbliebene Ätzresiduen aus Polysilizium durch Überätzen entfernt. Dazu wird die 100 kHz-Leistung auf 15 Watt eingestellt. Der dritte Schritt wird 90 bis 120 Sekunden durchgeführt. Die erforderliche Dauer hängt von der Topologie der Strukturenart auf dem Substrat ab. Die freiliegenden Bereiche der unteren Schicht zeigen nach dieser Ätzzeit keinen Ätzangriff. Versuche haben gezeigt, daß auch nach 480 Sekunden Überätzen die untere Schicht aus SiO₂ in der Dicke unverändert erhalten bleibt.

Das geschilderte Ausführungsbeispiel kann mit denselben Prozeßparametern auch unter Verwendung von reinem Br₂ oder einem Gemisch aus Cl₂/Br₂ durchgeführt werden.

## Patentansprüche

1. Verfahren zur Strukturierung einer Polysiliziumschicht,
- bei dem ein anisotroper Plasmaätzprozeß in einem Ätzreaktor (1) mindestens mit einer geerdeten Elektrode (9), einem Scheibenhalter (4) und einer Ringelektrode (10), die den Scheibenhalter (4) ringförmig umgibt, durchgeführt wird, in dem über den Scheibenhalter (4) und über die Ringelektrode (10) unabhängig voneinander zwei RF-Leistungen unterschiedlicher Frequenz eingekoppelt werden,
- bei dem ein Substrat (7) mit einem Schichtaufbau (8), der mindestens eine untere Schicht aus SiO₂ und die zu strukturierende Polysiliziumschicht enthält, in den Ätzreaktor (1) eingebracht wird,
- bei dem in dem Atzreaktor (1) ein Target (14) vorgesehen ist, das SiO₂ enthält,
- bei dem die RF-Leistung an der Ringelektrode (10) so eingestellt wird, daß SiO₂ aus dem Target (14) gesputtert wird und daß sich SiO₂ auf Oberflächen der unteren Schicht, die während des Ätzprozesses unter Verwendung eines Ätzgases freigelegt werden, im wesentlichen in dem Maß ablagert, in dem die untere Schicht von dem Ätzprozeß angegriffen wird.

2. Verfahren nach Anspruch 1,
bei dem auf der zu strukturierenden Polysiliziumschicht eine Ätzmaske angeordnet ist.

3. Verfahren nach Anspruch 1 oder 2,
bei dem in dem Ätzreaktor (1) dem Scheibenhalter (4) gegenüber die geerdete Elektrode (9) angeordnet ist, bei dem an der Ringelektrode (10) und an der geerdeten Elektrode (9) Permanentmagneten (11) angeordnet sind und bei dem im Ätzreaktor (1) ein Gasdruck unter 1.3 Pa (10 mTorr) eingestellt wird.

4. Verfahren nach Anspruch 3,
bei dem über die Ringelektrode (10) eine RF-Leistung mit einer Frequenz von 13,56 MHz und über den Scheibenhalter (4) eine RF-Leistung mit einer Frequenz von 100 kHz angelegt wird.

5. Verfahren nach einem der Ansprüche 1 bis 4,
bei dem als Target (14) eine Auskleidung des Ätzreaktors (1) aus Quarz verwendet wird, die mindestens die Ringelektrode (10) und die geerdete Elektrode (9) abdeckt und die Öffnungen (15) zum Gaseinlaß aufweist.

6. Verfahren nach einem der Ansprüche 1 bis 5,
bei dem als Ätzgas mindestens einer der Gase Cl₂ oder Br₂ oder ein Gemisch Cl₂/Bᵣ verwendet wird.

7. Verfahren nach Anspruch 6,
bei dem die 100 kHz RF-leistung im Bereich 10 bis 50 Watt, die 13,56 MHz RF-Leistung im Bereich 900 bis 1200 Watt, der Durchfluß des Ätzgases im Bereich 15 bis 25 sccm und der Gasdruck im Bereich 0.13 bis 0.65 Pa (1 bis 5 mTorr) eingestellt wird.

8. Anwendung eines Verfahrens nach einem der Ansprüche 1 bis 7 zur Herstellung mindestens einer Gateelektrode, die Polysilizium enthält.

9. Anwendung eines Verfahrens nach einem der Ansprüche 1 bis 7 zur Strukturierung einer Polysiliziumschicht in einem DRAM-Prozeß.

## Claims

1. Method for structuring a polysilicon layer,
- in which an anisotropic plasma-etching process is carried out in an etching reactor (1) at least having an earthed electrode (9), a wafer holder (4) and a ring electrode (10) that annularly surrounds the wafer holder (4), in which two RF powers of different frequency are coupled in independently of each other via the wafer holder (4) and via the ring electrode (10),
- in which a substrate (7) having a layer structure (8) that contains at least a lower SiO₂ layer and the polysilicon layer to be structured, is introduced into the etching reactor (1),
- in which a target (14) that contains SiO₂ is provided in the etching reactor (1),
- in which the RF power at the ring electrode (10) is set in such a way that SiO₂ is sputtered from the target (14) and SiO₂ deposits on surfaces of the lower layer that are exposed during the etching process with the use of an etching gas, the deposition being to substantially the same degree as the lower layer is attacked by the etching process.

2. Method according to Claim 1, in which an etching mask is arranged on the polysilicon layer to be structured.

3. Method according to Claim 1 or 2, in which the earthed electrode (9) is arranged opposite the wafer holder (4) in the etching reactor (1), in which permanent magnets (11) are arranged at the ring electrode (10) and at the earthed electrode (9), and in which a gas pressure of below 1.3 Pa (10 mtorr) is set in the etching reactor (1).

4. Method according to Claim 3, in which a RF power having a frequency of 13.56 MHz is applied via the ring electrode (10) and a RF power having a frequency of 100 kHz is applied via the wafer holder (4).

5. Method according to one of Claims 1 to 4, in which a quartz lining of the etching reactor (1) is used as the target (14), this lining covering at least the ring electrode (10) and the earthed electrode (9) and having openings (15) for gas admission.

6. Method according to one of Claims 1 to 5, in which at least one of the gases Cl₂ or Br₂ or a Cl₂/Br₂ mixture is used as the etching gas.

7. Method according to Claim 6, in which the 100 kHz RF power is set in the range of 10 to 50 watts, the 13.56 MHz RF power is set in the range of 900 to 1200 watts, the throughput of the etching gas is set in the range of 15 to 25 sccm and the gas pressure is set in the range of 0.13 to 0.65 Pa (1 to 5 mtorr).

8. Use of a method according to one of Claims 1 to 7 for producing at least one gate electrode that contains polysilicon.

9. Use of a method according to one of Claims 1 to 7 for structuring a polysilicon layer in a DRAM process.

## Revendications

1. Procédé pour la structuration d'une couche de polysilicium,
- dans lequel on effectue un processus de gravure anisotrope au plasma dans un réacteur de gravure (1) au moins muni d'une électrode (9) reliée à la terre, d'un support de disque (4) et d'une électrode annulaire (10) qui entoure de manière annulaire le support de disque (4), dans lequel sont alimentées, via le support de disque (4) et via l'électrode annulaire (10), indépendamment l'une de l'autre, deux puissances RF de fréquence différente,
- dans lequel on introduit dans le réacteur de gravure (1), un substrat (7) muni d'un stratifié (8) qui contient au moins une couche inférieure de SiO₂ et la couche de polysilicium à structurer,
- dans lequel, dans le réacteur de gravure (1), on prévoit une cible (14) qui contient du SiO₂,
- dans lequel on règle la puissance RF à l'électrode annulaire (10) de telle sorte que du SiO₂ soit pulvérisé hors de la cible (14) et de telle sorte que du SiO₂ se dépose sur des surfaces de la couche inférieure, qui sont mises à nu au cours du procédé de gravure en utilisant un gaz de gravure, essentiellement dans la mesure dans laquelle la couche inférieure est attaquée par le processus de gravure.

2. Procédé selon la revendication 1, dans lequel un masque de gravure est disposé sur la couche de polysilicium à structurer.

3. Procédé selon la revendication 1 ou 2, dans lequel, dans le réacteur de gravure (1), l'électrode (9) raccordée à la terre est disposée face au support de disque (4), dans lequel des aimants permanents (11) sont disposés contre l'électrode annulaire (10) et contre l'électrode (9) reliée à la terre, et dans lequel on règle une pression de gaz inférieure à 1,3 Pa (10 mtorr) dans le réacteur de gravure (1).

4. Procédé selon la revendication 3, dans lequel, via l'électrode annulaire (10), on applique une puissance RF avec une fréquence de 13,56 MHz et via le support de disque (4), on applique une puissance RF avec une fréquence de 100 kHz.

5. Procédé selon l'une quelconque des revendications 1 à 4, dans lequel, comme cible (14), on utilise un revêtement en quartz du réacteur de gravure (1) qui recouvre au moins l'électrode annulaire (10) et l'électrode (9) reliée à la terre, et qui présente des ouvertures (15) pour l'entrée du gaz.

6. Procédé selon l'une quelconque des revendications 1 à 5, dans lequel, comme gaz de gravure, on utilise au moins un des gaz ci-après: Cl₂, Br₂ ou un mélange Cl₂/Br₂.

7. Procédé selon la revendication 6, dans lequel on règle la puissance RF de 100 kHz dans le domaine de 10 à 50 watt, la puissance RF de 13,56 MHz dans le domaine de 900 à 1200 watt, le débit du gaz dans le domaine de 15 à 25 sccm et la pression du gaz dans le domaine de 0,13 à 0,65 Pa (1 à 5 mtorr).

8. Application d'un procédé selon l'une quelconque des revendications 1 à 7, pour la préparation d'au moins une électrode de grille qui contient du polysilicium.

9. Application d'un procédé selon l'une quelconque des revendications 1 à 7, pour la structuration d'une couche de polysilicium dans un procédé à RAM dynamique.
